# EUROPEAN PATENT SPECIFICATION

(11) **EP 2 515 124 B1**
(45) Date of publication and mention of the grant of the patent: **22.06.2016**
(21) Application number: 12002706.5
(22) Date of filing: 18.04.2012
(51) Int. Cl.: G01R 15/18, G01R 15/20

(54) **Current sensor operating in accordance with the principale of compensation**
Gemäß den Prinzipien der Kompensation betriebener Stromsensor
Capteur de courant fonctionnant selon le principe de la compensation

(30) Priority: 21.04.2011 EP 11003398
(43) Date of publication of application: 24.10.2012
(73) Proprietor: ABB AG, 68309 Mannheim (DE)
(72) Inventor: Hozoi, Adrian, 68219 Mannheim (DE); Disselnkötter, Rolf, 69256 Mauer (DE)

(56) References cited:
- DE-A1- 19 705 767
- US-A- 5 146 156
- US-A- 5 654 630
- US-A1- 2004 204 875

## Description

The invention relates to a current sensor operating in accordance with the principle of compensation, comprising a primary coil through which the current to be measured flows and thereby creates a magnetic field, further comprising a secondary coil with the two coils being magnetically coupled by means of a gapped magnetic core, where a compensation current flows through the secondary coil, which generates a magnetic field compensating that of the primary coil, further comprising a terminating resistor connected in series to the secondary coil, further comprising sensor means which are exposed to the resulting magnetic field of the primary and secondary coils, further comprising a booster circuit connected downstream of the sensor means which is feeding the compensation current to the secondary coil via the terminating resistor, wherein the booster circuit comprises a switched mode amplifier which includes a modulator, further comprising a power MOSFET output bridge with a first and a second power MOSFET.

Current sensors operating in accordance with the principle of compensation are often also called closed loop current sensors. Closed loop current sensors are based on a magnetic circuit, called core, of a highly permeable material which encloses a primary winding with the current that is to be measured. A flux sensor element located in the magnetic circuit, e.g. in an air gap, will detect any magnetic flux induced in this circuit and will generate a proportional signal. This signal is amplified by some electronic power stage, called booster circuit, which will generate a current through a secondary winding. This current is opposed to the primary current, establishing a negative feed-back, and it will compensate its effect on the magnetic circuit, apart from a small magnetic induction which is required as the actuating variable for the operation of the feedback loop. This residual induction corresponds to a current error of the whole sensor and needs to be kept small. This can be achieved by designing the amplifier for a very high gain, in terms of secondary current per magnetic induction of the core.

Prior art shows a way to reduce conduction losses in the booster circuit by using a switched mode amplifier with a pulse-width modulation scheme instead of a linear amplifier. By continuously switching between full conduction and insulation, these types of devices significantly reduce the conduction losses, even though at the expense of some additional switching losses. Total losses will be usually still much lower as compared to linear amplifiers. A switched mode amplifier will generate a pulsed output voltage whose average will correspond to the output of a corresponding linear amplifier. A continuous output can be restored by means of appropriate filtering.

A closed loop current sensor with a switched mode amplifier is known from DE-OS-196 42 472, where the sensor uses a switchable booster for decreasing the power requirement for the compensation current, and for reducing the losses at an operation with excessive supply voltage, and which is controlled by a pulse width modulated gating signal, which possesses a duty cycle depending on the measured value.

US 6,713,999 B1 shows a current sensor which is provided with low-pass filters for stabilizing the pulse-width modulated compensation signal, where the current sensor is also provided with an additional RC element, and furthermore, a limiting means consisting of Zener diodes and an ohmic resistance is provided for suppressing fast current transients.

US 2004/0204875 A1 shows a current sensor using the compensation principle , where the magnetic field probe is supplied with a square wave voltage of a predetermined frequency, the probe signal is recorded by one or two comparators and the pulse width is digitally measured by counters, and the conventional analog final stage for the compensation current is replaced by a PWM end stage with a series connected sigma-delta modulator.

DE 197 05 767 A1 shows a current sensor working according to the compensation principle, wherein the magnetic field produced by the current to be measured and which flows through a primary winding is compensated by a compensating current in a secondary winding and wherein at least one sensor affected by the magnetic field detects divergences from the zero current in order to control the compensating current and supplies a driver circuit with said measuring value in order to produce a compensating current. The secondary winding is series connected to a terminal resistor at the output of the driver circuit. A current which is proportional to the current to be measured is applied to the terminal resistor. The driver circuit has a clocked amplifier device which generates a corresponding pulse-width modulated compensating current from the linear measuring value provided by the evaluation circuit in order to feed the secondary winding and the terminal resistor.

It has been proposed to use a booster circuit which comprises a switched mode amplifier with a pulse width and density modulator that operates based on pulse width and density modulation, turning the compensation current into a pulse width and density modulated current, with a switching frequency that is a function of the compensation current in the sense that the switching frequency is high at small currents and low at high currents. In such a configuration, the switching losses are lowest at large current when the conduction losses are maximum, and are highest at small current when the conduction losses are minimum. The pulse width and density modulation scheme results thus in an almost constant power dissipation profile versus the output current with low maximum losses. In addition, the ripple of a current sensor having a booster circuit which comprises a switched mode amplifier that operates based on pulse width and density modulation, decreases with increasing switching frequency, meaning that the ripple of the pulse width and density modulation is proportional to the output current. The relative ripple is thus optimized over the full output current range, allowing for simple and low cost filtering.

Closed loop current sensors are active sensors, which need an external power supply for the generation of the secondary current and for supplying the internal electronic circuit. Usually, they are designed for either unipolar or bipolar operation, i.e. the sensor output is either referenced to the lower rail voltage or to the mean voltage level. With a reference voltage of 0V the supply terminals of a unipolar sensor will be connected to the positive supply voltage and to 0V respectively, while with bipolar sensors they will be connected to the positive and the negative supply voltage.

In many applications, the operator can select the level of the supply voltage from a certain range, e.g. from 15 V to 24 V. Dependent on the supply voltages available in a given application the sensor can be alternatively operated at different voltage levels, which results in a higher flexibility. With a higher supply voltage the closed loop current sensor can operate up to higher primary currents in active mode, i.e. within a larger dynamic range, while the losses will be smaller if a lower supply voltage is used at lower currents.

Therefore, it is an advantage, if a closed loop current sensor can be operated at still lower supply voltages, when required.

In order to supply the components of the sensor circuitry which have different supply voltage levels, further internal supply voltages need to be derived from the external power supply. It has been proposed to use a first linear voltage regulator to supply a first group of small signal components of the sensor circuitry, e.g. pre-amplifiers, the modulator, the Hall sensor, with a supply voltage typically between for example 3 V and 5 V. In order to control the power MOSFETs of the output bridge, there is in prior art applications usually an additional gate drive unit required, having low output impedances, which is used to control the gates of the power MOSFETs of the output bridge by providing the required voltage levels and peak currents. Known gate drive units typically require a supply voltage between 8 V and 16 V. Therefore, a second voltage regulator able to supply at least 8 V is required for this purpose in known circuitry according to the prior art.

It is therefore the problem to be solved by the present invention to provide a closed loop current sensor which avoids the need for a second internal power supply and a dedicated gate drive unit in the sensor electronics, in order to simplify the electronics circuitry.

The problem is solved according to the invention by a closed loop current sensor, as defined in claim 1, operating in accordance with the principle of compensation, comprising a primary coil through which the current to be measured flows, creating a magnetic field, further comprising a secondary coil, through which a compensation current flows, which generates a magnetic field compensating the primary coil, further comprising a terminating resistor connected in series to the secondary coil, further comprising sensor means which are exposed to the resulting magnetic field of the primary and secondary coils, further comprising a booster circuit connected downstream of the sensor means on the input side and feeding the compensation current to the secondary coil via the terminating resistor, wherein the booster circuit comprises a switched mode amplifier with a modulator, further comprising a power MOSFET output bridge with a first and a second power MOSFET, whereby the modulator has two complementary outputs and whereby the gate of the first MOSFET, which is on the low side of the bridge, is connected to a first modulator output, and whereby the gate of the second MOSFET, which is on the high side of the bridge, is connected to a second modulator output, which is complementary to the first modulator output, via a pulse transformer, and whereby further the gate of the second MOSFET is connected to a discharge circuit in order to effectively turn off the gate when the second MOSFET is turned off.

According to a preferred embodiment of the invention the modulator operates based on pulse width and density modulation, with a switching frequency that is a function of the compensation current in the sense that the switching frequency is high at small currents and low at high currents.

The circuitry according to the invention is providing an alternative method for controlling the gates of the power MOSFETs, with no need for a dedicated gate drive unit. The desired drive voltage is provided through a passive component, the pulse transformer, which allows to make the voltage shift required for the high-side MOSFET.The sensor according to the invention can be operated over a very wide supply range. At small currents, the sensor can be operated with very low supply voltages, down to approximately 5 V. The inventive principle can be used both with unipolar or with bipolar current sensors. The inventive principle can further be used both with half- and full-bridge power stages. The system cost of a current sensor according to the invention is reduced as no second voltage regulator and no dedicated gate drive unit is required.

According to a preferred embodiment of the invention, the gate of the first MOSFET of the MOSFET output bridge is connected to the first modulator output via a resistor.

According to a further preferred embodiment of the invention, the gate of the first MOSFET is connected to a turn-off circuit which is controlled by the second modulator output to boost the turning off of the first MOSFET. Faster switching with lower losses is then achieved. In a further embodiment, the turn-off circuit may comprise a bipolar transistor or a MOSFET.

According to a further preferred embodiment of the invention, the pulse transformer features a transformation ratio around 1 or higher, selected to reach the desired drive voltage.

According to a further preferred embodiment of the invention, a blocking circuit is foreseen between the pulse transformer and the second power MOSFET in order to ensure optimum switching. In yet a further preferred embodiment, the blocking circuit comprises a low threshold Schottky diode, which is used to rectify the positive pulse coming from the pulse transformer and to maintain a positive voltage drop on the gate of the second power MOSFET during the conduction period.

According to a further embodiment of the invention, the discharge circuit employs one bipolar transistor and a diode featuring very low cost. Of course, the invention is not limited to such an embodiment and other implementations are possible without leaving the scope of the invention.

According to a further embodiment of the invention, the power MOSFETs feature small storage capacitors connected between the gate and the source.

The foregoing, and other features and advantages of the present invention, will become more apparent in the light of the above-mentioned description and the accompanying drawings, where:
- Figure 1: shows schematic of a closed loop current sensor setup,
- Figure 2: shows a block diagram of the booster circuit in a first embodiment,
- Figure 3: shows a preferred embodiment for the inventive circuitry applied between the modulator and the power MOSFET output bridge.

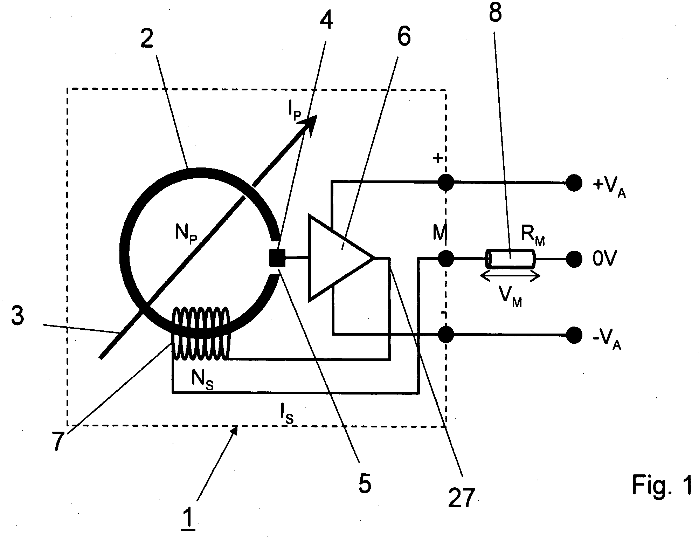

Elements with the same function and mode of operation are provided in the figures 1 to 3 with the same references.

Fig. 1 shows schematically a closed loop current sensor arrangement 1. The sensor is based on a magnetic circuit comprising a magnetic core 2 of a highly permeable material. The magnetic core 2 is enclosed by a primary coil 3 with a number of primary windings N_{P} with the current I_{P} that is to be measured. In the arrangement shown in figure 1 the primary coil 3 consists of only one winding. A flux sensor element 4 located in the air gap 5 of the magnetic core 2 will detect any magnetic flux induced in the magnetic circuit and will generate a proportional signal. This signal of the flux sensor element is amplified by an electronic power stage as part of a booster circuit 6.

The booster circuit 6 generates at its output 27 a secondary current I_{S} which flows through a secondary coil 7 that also encloses the magnetic core 2 and has a number of secondary windings N_{S}.

The secondary current is opposed to the primary current, creating a negative feedback. It will compensate the effect of the primary current on the magnetic circuit, apart from a small magnetic induction which is required as the actuating variable for the operation of the feedback loop. This residual induction corresponds to a current error of the whole sensor arrangement 1 and needs to be kept small. This can be achieved by designing the amplifier for a very high gain.

The booster circuit 6 is supplied by a power supply +V_{A} and - V_{A}. The magnitude of the secondary current I_{S} is measured with a terminating resistor 8, also called measuring resistor R_{M}, connected in series to the secondary winding N_{S}, here further connected to ground potential. The voltage drop V_{M} across the measuring resistor R_{M} is an indication for the secondary current I_{S} and thus gives the measurement value for the primary current I_{P}.

The booster circuit 6 comprises a switched mode amplifier which operates with a pulse width and density modulator that operates based on pulse width and density modulation, turning the compensation current into a pulse width and density modulated current, with a switching frequency that is a function of the compensation current in the sense that the switching frequency is high at small currents and low at high currents.

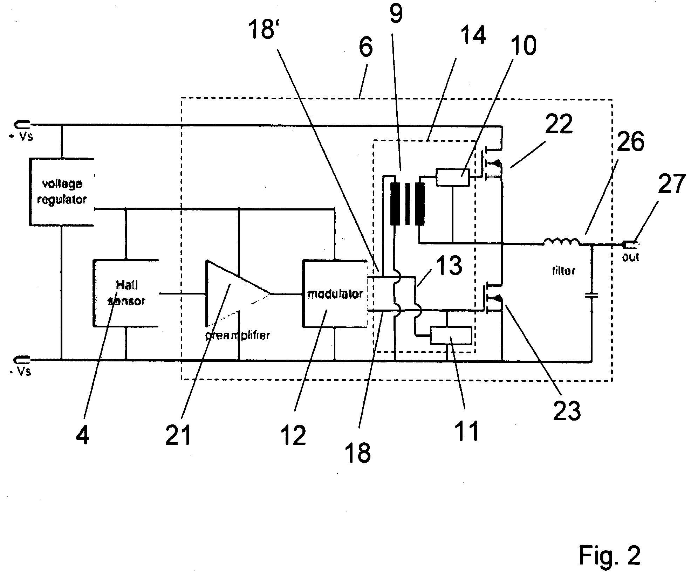

Figure 2 shows schematically the integration of the inventive circuitry 14 applied between the modulator 12 and the power MOSFET output bridge of the booster circuit 6.

The booster circuit 6 comprises a preamplifier 21, followed by the modulator 12 with two complementary outputs 18, 18'. At the output side of the booster circuit 6 there is a power stage with a power MOSFET-halfbridge, having a first MOSFET 23 and a second MOSFET 22. The first MOSFET 23 is connected to the negative supply voltage -V_{S}, that is why it is called also low-side MOSFET. The second MOSFET 22 is connected to the positive supply voltage +V_{S}, that is why it is called also high-side MOSFET.

The gate of the first MOSFET 23 is connected to a first modulator output 18. The gate of the second MOSFET 22 is connected to the second modulator output 18', which is complementary to the first modulator output 18, via a pulse transformer 9. The pulse transformer features a transformation ratio around 1 or higher, selected to reach the desired drive voltage for the power MOSFET half bridge 22, 23.

In addition, the gate of the second MOSFET 22 is connected to a blocking and discharge circuit 10 in order to effectively keep the transitor gate voltage on high level when the MOSFET 22 shall be in on-state and to force the gate voltage to low when the second MOSFET 22 shall be turned off.

The gate of the first MOSFET 23 is further connected to a turn-off circuit 11 which is controlled by the second modulator output 18' via a connection line 13 to boost the turning off of the first MOSFET 23.

So between the modulator 12 and the pair of high-power MOSFETs 22, 23, there is the circuitry comprising the pulse transformer 9, the blocking and discharge unit 10 and the turn-off circuit 11. In order to achieve good matching and switching performance, the half bridge is preferably built from two n-type MOSFETs, however the use of complementary MOSFETs is also possible. As an alternative, the principle can also be used with a full bridge instead of a half bridge of power switches.

Downstream of the MOSFET halfbridge 22, 23 there is a low pass output filter 26, here with an RC arrangement, which removes the high-frequency switching components of the modulated signal. The filtered current signal is then fed through the secondary coil 7, see fig. 1.

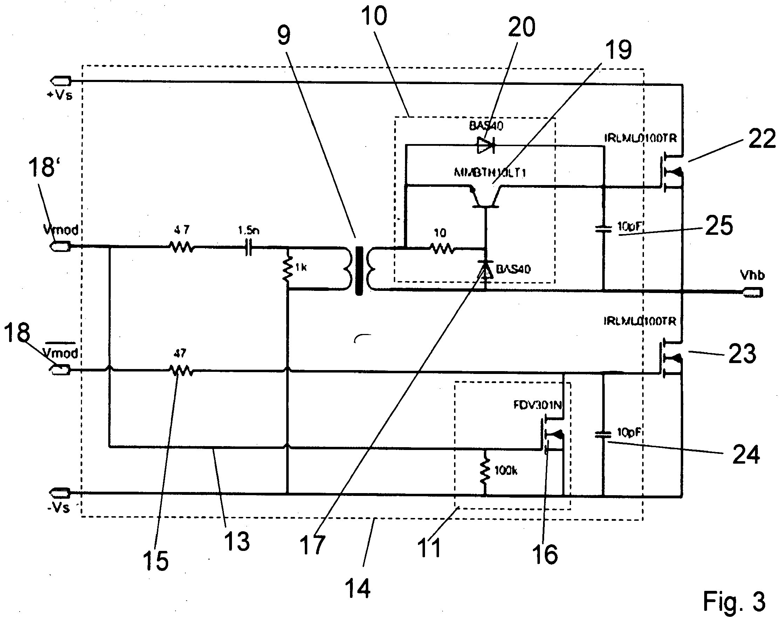

Figure 3 shows an embodiment of a realisation of the circuitry 14 applied between the modulator 12 and the power MOSFET output bridge 22, 23, which in figure 2 is shown in a schematic way.

The gate of the first MOSFET 23 is connected to the first modulator output 18 via a resistor 15.

The turn-off circuit 11 is realized with a transistor 16, which may be FET or a bipolar transistor and which is controlled by the other complementary output 18' of the modulator 12, and is used to boost the turn-off of the low side power MOSFET 23. Faster switching with lower losses is then achieved. Other implementations of the turn-off circuit are also possible.

The complementary output 18' of the modulator 12 is connected to the high side power MOSFET 22 via a simple and very low cost pulse transformer 9. The transformer 9 features a transformation ratio around 1 or higher, selected to reach the desired drive voltage.

A blocking circuit, e.g. a low threshold Schottky diode 17, is used to rectify the positive pulse coming from the transformer 9 and maintain a positive voltage drop on the gate of the power MOSFET 22 during its conduction time.

A discharge circuit 10 is used between the transformer 9 and the high side power MOSFET 22 in order to ensure optimum switching. The discharge circuit 10 discharges efficiently the gate of the high side MOSFET 22 when turned off. The discharge circuit 11 employs one bipolar transistor 19 and a diode 17 featuring very low cost. However, other implementations are of course also possible.

The power MOSFETs 22, 23 may feature small storage capacitors 24, 25 connected between the gate and the source.

**Figure legend:**

| | |
|---|---|
| 1 | Closed loop current sensor arrangement |
| 2 | Magnetic core |
| 3 | Primary coil |
| 4 | Flux sensor element |
| 5 | Air gap |
| 6 | Booster circuit |
| 7 | Secondary coil |
| 8 | Terminating resistor |
| 9 | Pulse transformer |
| 10 | Blocking and discharge circuit |
| 11 | Turn-off circuit |
| 12 | Modulator |
| 13 | Connection line |
| 14 | Circuitry |
| 15 | Resistor |
| 16 | Transistor |
| 17 | Diode |
| 18, 18' | Outputs of the modulator |
| 19 | Bipolar transistor |
| 20 | Diode |
| 21 | Preamplifier |
| 22 | High-power MOSFET |
| 23 | High-power MOSFET |
| 24 | Storage capacitor |
| 25 | Storage capacitor |
| 26 | Output filter |
| 27 | Output of the booster circuit |

## Claims

1. Current sensor (1) operating in accordance with the principle of compensation, comprising a gapped magnetic core (2) with
- a primary coil (3) through which the current to be measured flows, creating a magnetic field,
- a secondary coil (7), through which a compensation current flows, which generates a magnetic field compensating that of the primary coil (3),
- a terminating resistor (8) connected in series to the secondary coil (7),
- sensor means (4), which are exposed to the resulting magnetic field of the primary and secondary coils (3, 7),
- a booster circuit (6) connected downstream of the sensor means (4) which feeds the compensation current to the secondary coil (7) via the terminating resistor (8), wherein the booster circuit (6) comprises a switched mode amplifier including a pulse width and density_modulator (12), and a power MOSFET output bridge with at least a first and a second power MOSFET (22, 23),
**characterized in that** the modulator (12) has two complementary outputs (18, 18'), and that the gate of the first MOSFET (23) is connected to a first modulator output (18), and that the gate of the second MOSFET (22) is connected to a second modulator output (18'), which is complementary to the first modulator output (18), via a cascade connection of the pulse transformer (9) and the blocking and discharge circuit (10) in order to effectively control the gate when the second MOSFET (22) is to be switched on or off.

2. Current sensor (1) according to claim 1, whereby the modulator (12) operates based on pulse width and density modulation, with a switching frequency that is a function of the compensation current in the sense that the switching frequency is high at small currents and low at high currents.

3. Current sensor (1) according to claim 2 whereby the gate of the first MOSFET (23) is connected to the first modulator output (18) via a resistor (15).

4. Current sensor (1) according to claim 2, whereby the gate of the first MOSFET (23) is connected to a turn-off circuit (11) which is controlled by the second modulator output (18') to boost the turning off of the first MOSFET (23).

5. Current sensor (1) according to claim 2, whereby the pulse transformer (9) features a transformation ratio around 1 or higher.

6. Current sensor (1) according to claim 1, whereby a blocking circuit is foreseen between the transformer (9) and the second power MOSFET (22) in order to ensure optimum switching.

7. Current sensor (1) according to claim 6, whereby the blocking and discharge circuit (10) comprises a low threshold Schottky diode (20), which is used to rectify the positive pulse coming from the pulse transformer (9) and to maintain a positive gate-source voltage of the second power MOSFET (22) during the conduction time.

8. Current sensor (1) according to claim 2, whereby the blocking and discharge circuit (10) employs one bipolar transistor (19) and a diode (17) for a faster discharge of the gate of the second MOSFET (22).

9. Current sensor (1) according to claim 2, whereby the power MOSFETs (22, 23) feature small storage capacitors (24, 25) connected between the gate and the source.

## Patentansprüche

1. Stromsensor (1), der gemäß den Prinzipien der Kompensation betrieben wird und der umfasst: einen gespaltenen magnetischen Kern (2) mit
- einer Primärspule (3), durch die der zu messende Strom fließt, wobei er ein Magnetfeld erzeugt,
- einer Sekundärspule (7), durch die ein Kompensationsstrom fließt, der ein magnetisches Feld erzeugt, das das Feld der Primärspule (3) kompensiert,
- einem Abschlusswiderstand (8), der in Reihe mit der Sekundärspule (7) geschaltet ist,
- Sensormitteln (4), die dem resultierenden magnetischen Feld der Primärspule und der Sekundärspule (3, 7) ausgesetzt sind,
- einer Verstärkerschaltung (6), die stromabwärts nach den Sensormitteln (4) angeschlossen ist, die den Kompensationsstrom über den Abschlusswiderstand (8) in die Sekundärspule (7) einspeist, wobei die Verstärkerschaltung (6) einen Schaltmodusverstärker, der einen Impulsbreiten- und Impulsdichtemodulator (12) enthält, und eine Leistungs-MOSFET-Ausgangsbrücke mit mindestens einem ersten und einem zweiten Leistungs-MOSFET (22, 23) umfasst,
**dadurch gekennzeichnet, dass** der Modulator (12) zwei komplementäre Ausgänge (18, 18') besitzt und dass das Gate des ersten MOSFET (23) an einen ersten Modulatorausgang (18) angeschlossen ist und dass das Gate des zweiten MOSFET (22) über eine Kaskadenverbindung des Impulsumsetzers (9) und der Sperr- und Entladeschaltung (10) an einen zweiten Modulatorausgang (18') angeschlossen ist, der zu dem ersten Modulatorausgang (18) komplementär ist, um das Gate effektiv zu steuern, wenn der zweite MOSFET (22) eingeschaltet oder ausgeschaltet werden soll.

2. Stromsensor (1) nach Anspruch 1, wobei der Modulator (12) auf der Basis von Impulsbreiten- und Impulsdichtemodulation mit einer Schaltfrequenz arbeitet, die eine Funktion des Kompensationsstroms ist in dem Sinn, dass die Schaltfrequenz für kleine Ströme hoch und für hohe Ströme niedrig ist.

3. Stromsensor (1) nach Anspruch 2, wobei das Gate des ersten MOSFET (23) über einen Widerstand (15) an den ersten Modulatorausgang (18) angeschlossen ist.

4. Stromsensor (1) nach Anspruch 2, wobei das Gate des ersten MOSFET (23) an eine Abschaltschaltung (11) angeschlossen ist, die durch den zweiten Modulatorausgang (18') gesteuert wird, um das Abschalten des ersten MOSFET (23) zu verstärken.

5. Stromsensor (1) nach Anspruch 2, wobei der Impulsumsetzer (9) ein Umsetzungsverhältnis von ungefähr 1 oder höher aufweist.

6. Stromsensor (1) nach Anspruch 1, wobei eine Sperrschaltung zwischen dem Umsetzer (9) und dem zweiten Leistungs-MOSFET (22) vorgesehen ist, um ein optimales Schalten sicherzustellen.

7. Stromsensor (1) nach Anspruch 6, wobei die Sperr- und Entladeschaltung (10) eine Schottky-Diode (20) mit einem niedrigen Schwellenwert umfasst, die verwendet wird, um den positiven Impuls, der von dem Impulsumsetzer (9) kommt, gleichzurichten und um während der Leitungsdauer eine positive Gate-Source-Spannung des zweiten Leistungs-MOSFET (22) aufrechtzuerhalten.

8. Stromsensor (1) nach Anspruch 2, wobei die Sperr- und Entladeschaltung (10) einen bipolaren Transistor (19) und eine Diode (17) für ein schnelleres Entladen des Gates des zweiten MOSFET (22) benutzt.

9. Stromsensor (1) nach Anspruch 2, wobei die Leistungs-MOSFETs (22, 23) kleine Speicherkondensatoren (24, 25) aufweisen, die zwischen dem Gate und der Source angeschlossen sind.

## Revendications

1. Capteur de courant (1) fonctionnant conformément au principe de compensation, comprenant un noyau magnétique à entrefer (2) comportant :
- une bobine primaire (3), à travers laquelle passe le courant à mesurer, créant un champ magnétique,
- une bobine secondaire (7), à travers laquelle passe un courant de compensation, qui génère un champ magnétique compensant celui de la bobine primaire (3),
- une résistance de terminaison (8) connectée en série à la bobine secondaire (7),
- des moyens capteurs (4), qui sont exposés au champ magnétique résultant des bobines primaire et secondaire (3, 7),
- un circuit survolteur (6) connecté en aval des moyens capteurs (4), qui applique le courant de compensation à la bobine secondaire (7) par l'intermédiaire de la résistance de terminaison (8), dans lequel le circuit survolteur (6) comprend un amplificateur à mode commuté comportant un modulateur de largeur d'impulsion et de densité (12), et un pont de sortie à MOSFET de puissance comportant au moins un premier et un second MOSFET de puissance (22, 23),
**caractérisé en ce que** le modulateur (12) comporte deux sorties complémentaires (18, 18') et **en ce que** la grille du premier MOSFET (23) est connectée à une première sortie de modulateur (18), et **en ce que** la grille du second MOSFET (22) est connectée à une seconde sortie de modulateur (18'), qui est complémentaire de la première sortie de modulateur (18), par l'intermédiaire d'une connexion en cascade du transformateur d'impulsion (9) et du circuit de blocage et de décharge (10), afin de commander de manière effective la grille lorsque le second MOSFET (22) doit être commuté à l'état passant ou non passant.

2. Capteur de courant (1) selon la revendication 1, dans lequel le modulateur (12) fonctionne sur la base d'une modulation d'impulsion en largeur et de densité, avec une fréquence de commutation qui est fonction du courant de compensation au sens où la fréquence de commutation est élevée pour les courants faibles et est faible pour les courants forts.

3. Capteur de courant (1) selon la revendication 2, dans lequel la grille du premier MOSFET (23) est connectée à la première sortie de modulateur (18) par l'intermédiaire d'une résistance (15).

4. Capteur de courant (1) selon la revendication 2, dans lequel la grille du premier MOSFET (23) est connectée à un circuit de désactivation (11) qui est commandé par la seconde sortie de modulateur (18') pour survolter la désactivation du premier MOSFET (23).

5. Capteur de courant (1) selon la revendication 2, dans lequel le transformateur d'impulsion (9) présente un rapport de transformation voisin de 1 ou plus.

6. Capteur de courant (1) selon la revendication 1, dans lequel un circuit de blocage est prévu entre le transformateur (9) et le second MOSFET de puissance (22) afin de garantir une commutation optimale.

7. Capteur de courant (1) selon la revendication 6, dans lequel le circuit de blocage et de décharge (10) comprend une diode Schottky à faible seuil (20) qui est utilisée pour redresser l'impulsion positive provenant du transformateur d'impulsion (9) et pour maintenir une tension grille-source positive du second MOSFET de puissance (22) pendant le temps de conduction.

8. Capteur de courant (1) selon la revendication 2, dans lequel le circuit de blocage et de décharge (10) utilise un transistor bipolaire (19) et une diode (17) pour une décharge plus rapide de la grille du second MOSFET (22).

9. Capteur de courant (1) selon la revendication 2, dans lequel les MOSFET de puissance (22, 23) comportent de petits condensateurs de stockage (24, 25) connectés entre la grille et la source.
